Europäisches Patentamt

European Patent Office

Office européen des brevets

(11) Publication number: **0 201 171 B1**

(19)

(12) **EUROPEAN PATENT SPECIFICATION**

(45) Date of publication of patent specification: **01.07.92**   (51) Int. Cl.⁵: **H01C 7/02**, H01C 1/14, H01C 1/01

(21) Application number: **86301853.7**

(22) Date of filing: **14.03.86**

(54) **Conductive polymer-based PTC devices.**

(30) Priority: **14.03.85 US 711790**

(43) Date of publication of application:
**12.11.86 Bulletin 86/46**

(45) Publication of the grant of the patent:
**01.07.92 Bulletin 92/27**

(84) Designated Contracting States:
**AT BE CH DE FR GB IT LI NL SE**

(56) References cited:
**EP-A- 0 087 884**
**DE-A- 1 540 409**
**FR-A- 2 320 678**
**US-A- 4 318 073**

(73) Proprietor: **RAYCHEM CORPORATION (a Delaware corporation)**
**300 Constitution Drive**
**Menlo Park, California 94025(US)**

(72) Inventor: **Carlomagno, William D.**
**2072 Goodwin Avenue**
**Redwood City California 94061(US)**

(74) Representative: **Benson, John Everett et al**
**Raychem Limited Intellectual Property Law Department Faraday Road Dorcan**
**Swindon, Wiltshire SN3 5HH(GB)**

## Description

This invention relates to circuit protection devices comprising a PTC element composed of a conductive polymer element.

Documents describing conductive polymer compositions and devices comprising them include U.S. Patents Nos. 2,952,761, 2,978,665, 3,243,753, 3,351,882, 3,571,777, 3,757,086, 3,793,716, 3,823,217, 3,858,144, 3,861,029, 3,950,604, 4,017,715, 4,072,848, 4,085,286, 4,117,312, 4,177,376, 4,177,446, 4,188,276, 4,237,441, 4,242,573, 4,246,468, 4,250,400, 4,252,692, 4,255,698, 4,271,350, 4,272,471, 4,304,987, 4,309,596, 4,309,597, 4,314,230, 4,314,231, 4,315,237, 4,317,027, 4,318,881, 4,327,351, 4,330,704, 4,334,351, 4,352,083, 4,361,799, 4,388,607, 4,398,084, 4,413,301, 4,425,397, 4,426,339, 4,426,633, 4,427,877, 4,435,639, 4,429,216, 4,442,139, 4,459,473, 4,481,498, 4,476,450, 4,502,929; 4,514,620, 4,517,449, and 4,534,889; J. Applied Polymer Science 19, 813-815 (1975), Klason and Kubat; Polymer Engineering and Science 18, 649-653 (1978), Narkis et al; and commonly assigned U.S. Serial Nos. 601,424 now abandoned, published as German OLS No. 1,634,999; 732,792 (Van Konynenburg et al), now abandoned, published as German OLS No. 2,746,602; 798,154 (Horsma et al), now abandoned, published as German OLS No. 2,821,799; 141,984 (Gotcher et al), now abandoned, published as European Application No. 38,718; 141,988 (Fouts et al), now abandoned, published as European Application No. 38,718, 141,989 (Evans), published as European Application No. 38,713, 141,991 (Fouts et al), published as European Application No. 38,714, 150,909 (Sopory), published as UK Application No. 2,076,106A, 250,491 (Jacobs et al) published as European Application No. 63,440, 274,010 (Walty et al), now abandoned, 300,709 and 423,589 (Van Konynenburg et al), published as European Application No. 74,281, 369,309 (Midgley et al), published as European Application No. 92,406, 483,633 (Wasley), 606,033 (Leary et al), published as European Application No. 119,807, 599,047 and 598,048 (Masia et al), published as European Application No. 84,304,502.2, 524,482 (Tomlinson et al), published as European Application No. 84,305,584.7, 534,913 (McKinley), now abandoned, 552,649 (Jensen et al), published as European Application No. 84,307,984.9, 573,099 (Batliwalla et al) and 904,736 (Penneck et al), published as UK Patent Nos. 1,470,502 and 1,470,503, 650,918 (Batliwalla et al, MP0959), now abandoned, 650,920 (Batliwalla et al, MP0961-US1), now abandoned, 663,014 (Batliwalla et al, MP0961-US2), now abandoned, 735,408 (Batliwalla et al, MP0961-US3), 650,919 (Batliwalla et al, MP0962), 650,921 (Kheder, MP0973), 667,799 (Frank, MP0998), 711,908 (Ratell, MP1016), 687,120, (Leary et al, MP1017), 691,291 (Hauptly et al, MP1020), 711,907 (Ratell, MP1021), 711,909 (Deep et al, MP1022), 720,118 (Soni et al, MP1039), 711,910 (Au et al, MP1044), 716,780 (Sandberg, MP1048), 735,409 (Batliwalla et al, MP1062), 741,657 (Morrow et al, MP1069), 744,170 (Lahlough et al, MP1072), and 764,894 (Batliwalla et al, MP1073). The disclosure of each of the patents, publications and applications referred to above is incorporated herein by reference.

Particularly useful devices comprising PTC conductive polymers are circuit protection devices. Such devices have a relatively low resistance under the normal operating conditions of the circuit, but are "tripped", i.e., converted into a high resistance state, when a fault condition, e.g., excessive current or temperature, occurs. When the device is tripped by excessive current, the current passing through the PTC element causes it to self-heat to its switching temperature, $T_s$, at which it is in a high resistance state. The increase in resistance is accompanied by an expansion of the PTC element along an axis of expansion. Such devices, and PTC conductive polymer compositions for use in them, are described for example in U.S. Patents Nos. 4,237,411, 4,238,812; 4,255,698; 4,315,237; 4,317,027; 4,329,726; 4,352,083; 4,413,301; 4,450,496; 4,475,138; and 4,481,498 and in copending, commonly assigned US Application Serial Nos. 141,989 (MP0715), 524,482 (MP0751) and 628,945 (MP0906), and in the commonly assigned patent applications filed contemporaneously with this application by Deep et al, Serial No. 711,909 (MP1022), by Ratell, Serial No. 711,907 (MP1021), by Ratell, Serial No. 711,908 (MP1016), and by Au et al, Serial No. 711,910 (MP1044).

We have been working on the use of circuit protection devices containing PTC conductive polymer elements in situations in which the device is mounted onto, or itself comprises, a rigid wall which is spaced apart from the PTC element and through which the electrodes pass. In our work, we have discovered that the behavior of the device can be adversely affected if the electrodes, which are prevented from moving by the rigid wall, prevent the PTC element from expanding to the extent necessary to provide the desired PTC effect. These adverse effects, in extreme cases, can cause the PTC element to shatter explosively when subjected to conditions which, if the electrodes are not restrained by the rigid wall, will cause the device to trip in a controlled and predetermined way. The danger of encountering such adverse effects appears to increase as the distance between the PTC element and the rigid wall decreases (which is often highly desirable so that the device occupies as little space as possible) and as the voltage applied to the device increases. In its broadest aspect, this invention includes any novel means which lessens the danger that the PTC element, when it is tripped, is prevented from expanding to the extent necessary for effective operation by restraining forces exerted on it by the electrodes. The most convenient method of ensuring that excessive restraining forces are not applied to the PTC element through the electrodes is by selection of suitable electrodes, bearing in mind that the electrodes must not only be sufficiently flexible to avoid restraining the PTC element, but must in some cases have end portions (remote from the PTC element) which meet end use requirements such as termination to a circuit board or other physical and/or electrical connection device, as well as having the required current-carrying and heat-dissipating characteristics. Another expedient for achieving the desired result is the use of a wall (through which the electrodes pass) which will accommodate the expansive forces of the PTC element.

The invention is illustrated in the accompanying drawing, in which

Figure 1 is a cross-section through a device of the invention in which round leads have been rendered more flexible by deforming them into a doubled dimpled configuration which introduces areas of reduced section moduli;

Figure 2 is a cross-section on line 2-2 of Figure 1;

Figure 3 is a cross-section through another device of the invention in which the round electrodes are rendered more flexible by providing them with an S shaped configuration;

Figure 4 is a cross-section through another device of the invention in which the round electrodes are rendered more flexible by having both a looped and dimpled configuration;

Figure 5 is a cross-section through another device of the invention in which each of the electrodes comprises a stranded wire portion adjacent the PTC element and a solid wire portion remote from the PTC element;

Figure 6 is a cross-section on line 6-6 of Figure 5;

Figures 7 and 8 illustrate the determination of the bending resistance of the inner and outer portions of an electrode; and

Figure 9 is a circuit diagram for a circuit of the invention.

As noted above, the objects of the present invention are preferably achieved through the use of suitable electrodes, and the invention will chiefly be described by reference to this embodiment of the invention. Thus the invention provides

A circuit protection device which comprises

(1) a PTC element composed of a conductive polymer composition which exhibits PTC behavior and which comprises a polymeric component and, dispersed in the polymeric component, a particulate conductive filler; and

(2) two electrodes which are electrically connected to the PTC element and which are connectable to a source of electrical power to cause current to pass through the PTC element and thus to cause the PTC element to self-heat to a switching temperature $T_s$ and to expand along an axis of expansion, thus generating expansion forces which are transmitted to the electrodes;

at least one of said electrodes comprising

(a) a first portion which is in physical contact with the PTC element either directly, or indirectly through an element composed of a conductive polymer,

(b) a second inner portion which is not in contact with the PTC element, and

(c) a third outer portion which is not in contact with the PTC element;

the inner portion lying between the first portion and the outer portion, and having a resistance to bending, parallel to the axis of expansion of the PTC element, which is less than the resistance to bending, parallel to the axis of expansion of the PTC element, of the outer portion, said device being suitable for insertion into a rigid wall such that the inner portion of the electrode lies between the wall and the PTC element and the outer portion of the electrode lies on the other side of the wall, remote from the PTC element.

According to the invention, the inner portion has a lower resistance to bending than the outer portion, when subjected to forces parallel to the axis of expansion of the PTC element. The inner portion has a resistance to bending which is preferably less than 0.9, particularly less than 0.75, for example, less than 0.5, times the resistance to bending of the outer portion. The term "resistance to bending" is used herein to mean the quantity $\frac{F}{d}$, where F is the force required to move one end of the portion a distance of 0.0051 cm (2 mils), in a direction parallel to the axis of the PTC element, the portion being elastically deformed and the other end of the portion being maintained in a fixed position, and d is the distance between a first line which is parallel to the axis of expansion and which passes through one end of the portion and a second line which is parallel to the axis of expansion and which passes through the other end of the portion.

The two electrodes are generally made of metal and are preferably substantially identical. The first portions of the electrodes are preferably in direct physical contact with the PTC element, but can be separated therefrom by a layer of another conductive material, e.g., a zero temperature coefficient (ZTC) conductive polymer. The first portions of the electrodes can be of any configuration, eg planar sheet electrodes which are contacted by the PTC element on only one surface, or columnar electrodes which are surrounded by the PTC element, particularly round wires or thin metal strips.

In one embodiment each of the electrodes is composed of a single piece of solid metal which is shaped at one or more sections along its length to provide the second portion of greater flexibility. Especially because of heat dissipation requirements, such electrodes preferably have a substantially constant cross-sectional area. The electrodes are preferably substantially straight and parallel to each other, and especially in that case the second portion is preferably provided by one or more sections in which the cross-sectional dimension parallel to the axis of expansion of the PTC element is less than 0.9, preferably less than 0.8, e.g., less than 0.75, particularly less than 0.5, times the average cross-sectional dimension of the inner portion parallel to the axis of expansion of the PTC element. Alternatively or additionally, the second portion of greater flexibility can be provided by a substantially curved configuration, e.g., an S shape.

In another embodiment, each of the electrodes comprises first and inner portions which are in the form of a single piece of stranded metal wire, and an outer portion which is a solid wire and which is secured to, e.g. welded to, the second portion. The advantage of this embodiment is that the outer portion can be selected for its desired properties for connection to other electrical devices, for which stranded metal wires are often unsatisfactory.

The greater flexibility of the inner portion of the electrodes is especially useful in devices which comprise a rigid wall, e.g. the base of an enclosure which encloses one or more PTC elements, which is spaced apart from the PTC element and which contains two exit ports through each of which passes one of the electrodes. The second, inner portion lies between the wall and the PTC element, and the third, outer portion lies outside the wall.

The devices of the invention are particularly valuable in circuits which operate at relatively high voltages, e.g. 200 volts AC or higher, particulary at least 350 volts AC, especially at least 500 volts AC, e.g. 600 volts AC, or which under normal conditions operate at a lower voltage, e.g. 20 to 60 volts DC, but which may be exposed to much higher voltages, e.g. as described above, during a fault. Thus the present invention has been found to be very valuable in PTC devices for use as secondary protection against voltage spikes and current transients in subscriber loop interface circuits in telecommunication systems.

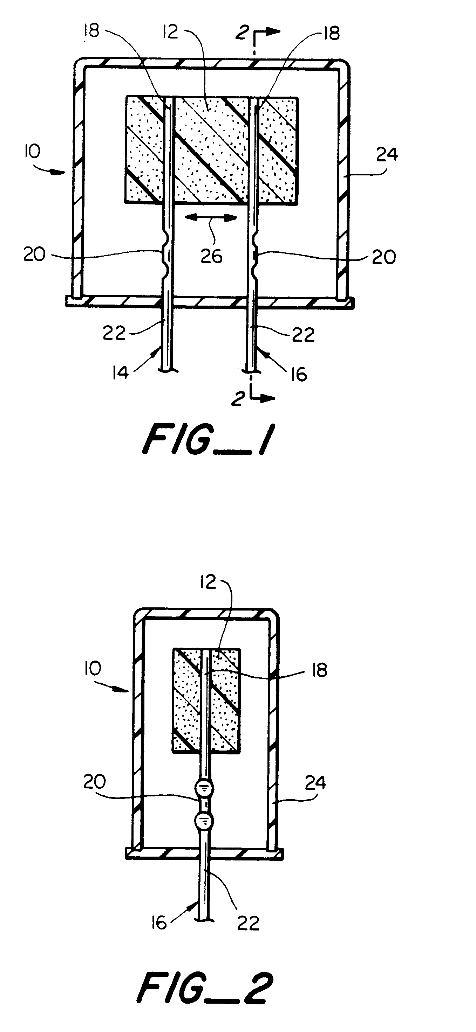

Referring now to the drawings, Figures 1 through 6 shows a means of providing flexibility to the inner portion of the electrodes. In particular, Figures 1 and 2 provide cross-sections through a device 10 of the invention. The device 10 includes a PTC element 12 composed of a conductive polymer composition which exhibits PTC behavior, and two electrodes 14 and 16 which are electrically connected to the PTC element. Each of the two electrodes 14 and 16 has a first portion 18 which is in physical contact with the PTC element, a second inner portion 20 which is not in contact with the PTC element, and a third outer portion 22 which is not in contact with the PTC element. Also shown is a rigid wall 24 which is spaced apart from the PTC element and which contains two exit ports through each of which passes one of the electrodes. The axis of expansion of the element 12 is along a line 26 . The inner portions 20 of the electrodes are round and have been rendered more flexible by deforming them into a double dimpled configuration, thus introducing areas of reduced section moduli.

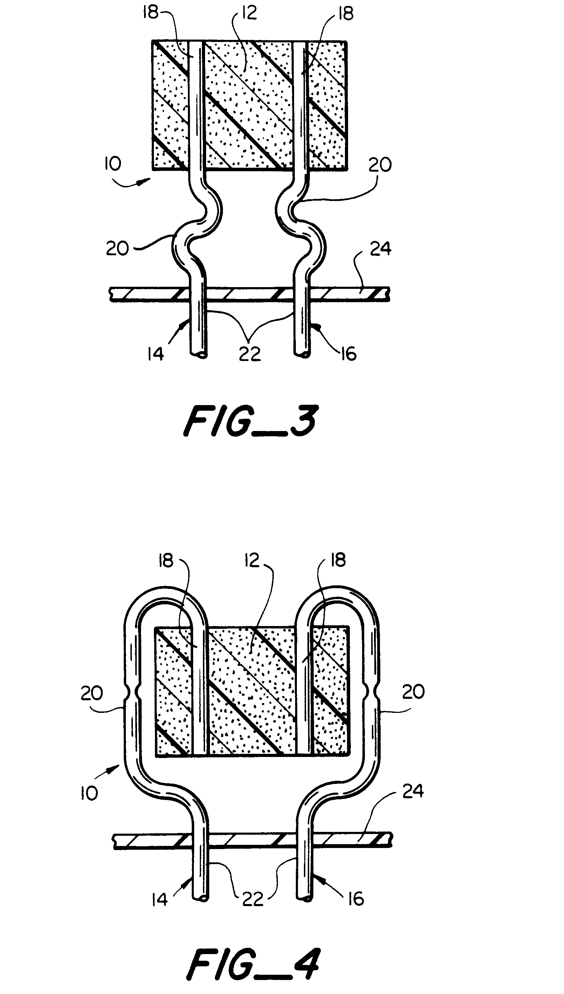

Figure 3 is similar to Figures 1 and 2 and shows the inner portions 20 of the electrodes formed in an S shape. Figure 4 also is similiar to Figures 1 and 2 and shows the inner portion 20 of the electrodes formed in a looped and dimpled configuration.

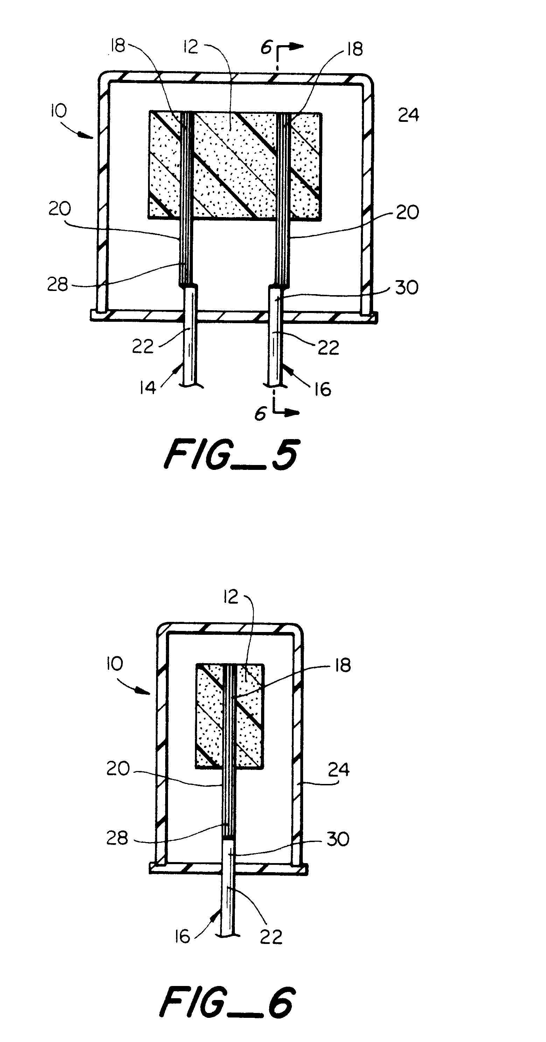

Figures 5 and 6 show an alternative embodiment wherein the inner portions 20 of the electrodes comprise a stranded portion 28 welded to a solid portion 30. Note that the method of attachment i.e. welding, can affect the flexibility of the inner portions 20.

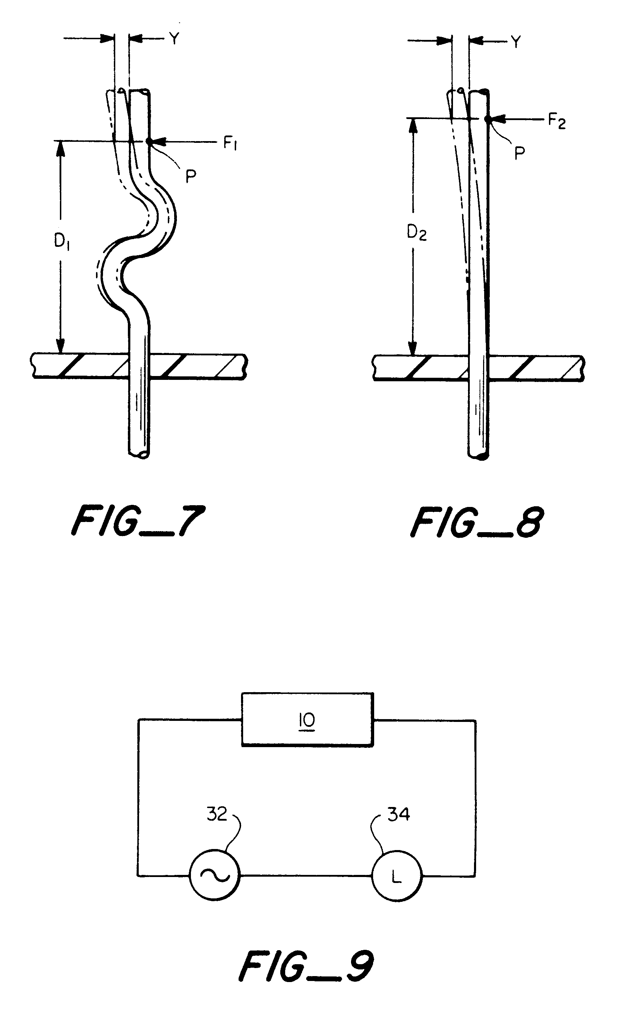

Figures 7 and 8 illustrate determination of the bending resistance of the inner and outer portions of the electrodes.

One end of a test electrode is fixed. A normal force F is applied to the test electrode at a point P which is some distance d from the fixed end of the test electrode. Sufficient force F is applied such that a predetermined amount of lateral deflection y of point P is obtained. F and D are measured and the value of F divided by D is determined. This is the description of the generic test. To test an electrode of the invention (Figure 7), the second portion of the electrode is subjected to the generic test and its value of $F_1$ divided by $D_1$ is determined. Then, the third portion of the electrode (Figure 8) is subjected to the generic test and its value of $F_2$ divided by $D_2$ is determined. Finally, $F_1$ divided by $D_1$ is compared to $F_2$ divided by $D_2$, and $F_1$ divided by $D_1$ is less than $F_2$ divided by $D_2$.

Referring now to Figure 9, this shows a circuit of the invention comprising a power supply 32, a circuit protection device 10 and an electrical load 34 in series therewith.

## Claims

1. A circuit protection device which comprises:

    (1) a PTC element composed of a conductive polymer composition which exhibits PTC behavior and which comprises a polymeric component and, dispersed in the polymeric component, a particulate conductive filler; and

    (2) two electrodes which are electrically connected to the PTC element and which are connectable to a source of electrical power to cause current to pass through the PTC element and thus to cause the PTC element to self-heat to a switching temperature $T_s$ and to expand along an axis of expansion, thus generating expansion forces which are transmitted to the electrodes;

    at least one of said electrodes comprising

    (a) a first portion which is in physical contact with the PTC element either directly, or indirectly through an element composed of a conductive polymer,

    (b) a second inner portion which is not in contact with the PTC element, and

    (c) a third outer portion which is not in contact with the PTC element;

    the inner portion lying between the first portion and the outer portion, and having a resistance to bending, parallel to the axis of expansion of the PTC element, which is less than the resistance to bending, parallel to the axis of expansion of the PTC element, of the outer portion, said device being suitable for insertion into a rigid wall such that the inner portion of the electrode lies between the wall and the PTC element and the outer portion of the electrode lies on the other side of the wall, remote from the PTC element.

2. A device according to Claim 1 wherein the inner portion has a resistance to bending which is less than 0.75 times the resistance to bending of the outer portion.

3. A device according to Claim 1 or 2 wherein the first portions of the electrodes are parallel to each other, are columnar in shape, and are surrounded by the PTC element.

4. A device according to Claim 1, 2 or 3 wherein the electrodes are substantially identical.

5. A device according to any of the preceding claims wherein each of the electrodes is a single piece of solid metal.

6. A device according to any of the preceding claims wherein each of the electrodes has a cross-sectional area which is the same throughout its length, and an inner portion which contains at least one section in which the cross-sectional dimension parallel to the axis of expansion of the PTC element is less than 0.8 times the average cross-sectional dimension of the inner portion parallel to the axis of expansion of the PTC element.

7. A device according to any of the preceding claims wherein each of the electrodes comprises first and inner portions which are in the form of a single piece of stranded metal wire, and an outer portion which is a solid wire.

8. A device according to any of the preceding claims which comprises a rigid wall which is spaced apart from the PTC element and which contains two exit ports through each of which passes one of the electrodes, and wherein in each of the electrodes, the inner portion lies between the wall and the PTC element and the outer portion lies on the other side of the wall, remote from the PTC element.

9. A circuit protection device according to any preceding claim, in combination, in an electrical circuit, with

    (a) a power source having a voltage V which is at least 20 volts DC; and
    (b) an electrical load;

    wherein the two electrodes of the circuit protection device are electrically connected in series to the load and to the power source to cause the said current to pass through the load and the PTC element.

10. An electrical circuit according to claim 9, which is liable to faults at voltages greater than 200 volts AC.

11. A method of making a device according to claim 8 by inserting a device as claimed in any one of claims 1 to 7 into a rigid wall, preferably a circuit board.

## Revendications

1. Dispositif de protection de circuit qui comporte :

    (1) un élément CPT composé d'une composition de polymère conducteur qui présente un comportement CPT et qui comprend un constituant polymérique et, en dispersion dans le constituant polymérique, une charge conductrice en particules ; et

(2) deux électrodes qui sont connectées électriquement à l'élément CPT et qui peuvent être connectées à une source d'énergie électrique pour faire passer un courant à travers l'élément CPT et amener ainsi l'élément CPT à s'échauffer de lui-même jusqu'à une température de commutation $T_s$ et à se dilater suivant un axe de dilatation, générant ainsi des forces de dilatation qui sont transmises aux électrodes ;

au moins l'une desdites électrodes comprenant

(a) un premier tronçon qui est en contact physique avec l'élément CPT, soit directement, soit indirectement par l'intermédiaire d'un élément composé d'un polymère conducteur,

(b) un second tronçon, intérieur, qui n'est pas en contact avec l'élément CPT, et

(c) un troisième tronçon, extérieur, qui n'est pas en contact avec l'élément CPT ;

le tronçon intérieur s'étendant entre le premier tronçon et le tronçon extérieur, et ayant une résistance à la flexion, parallèle à l'axe de dilatation de l'élément CPT, qui est inférieure à la résistance à la flexion, parallèle à l'axe de dilatation de l'élément CPT, du tronçon extérieur, ledit dispositif étant apte à une insertion dans une paroi rigide de manière que le tronçon intérieur de l'électrode s'étende entre la paroi et l'élément CPT et que le tronçon extérieur de l'électrode s'étende sur l'autre côté de la paroi, éloigné de l'élément CPT.

2.  Dispositif selon la revendication 1, dans lequel le tronçon intérieur possède une résistance à la flexion qui est inférieure à 0,75 fois la résistance à la flexion du tronçon extérieur.

3.  Dispositif selon la revendication 1 ou 2, dans lequel les premiers tronçons des électrodes sont parallèles entre eux, sont en forme de colonnes et sont entourés par l'élément CPT.

4.  Dispositif selon la revendication 1, 2 ou 3, dans lequel les électrodes sont sensiblement identiques.

5.  Dispositif selon l'une quelconque des revendications précédentes, dans lequel chacune des électrodes est une seule pièce en métal plein.

6.  Dispositif selon l'une quelconque des revendications précédentes, dans lequel chacune des électrodes présente une aire, en section transversale, qui est la même sur toute sa longueur, et un tronçon intérieur qui contient au moins une partie dans laquelle la dimension de la section transversale, parallèle à l'axe de dilatation de l'élément CPT, est inférieure à 0,8 fois la dimension moyenne de la section transversale du tronçon intérieur, parallèle à l'axe de dilatation de l'élément CPT.

7.  Dispositif selon l'une quelconque des revendications précédentes, dans lequel chacune des électrodes comporte un premier tronçon et un tronçon intérieur qui se présentent sous la forme d'une seule pièce de fil métallique multibrin, et un tronçon extérieur qui est un fil plein.

8.  Dispositif selon l'une quelconque des revendications précédentes, qui comporte une paroi rigide qui est espacée de l'élément CPT et qui contient deux orifices de sortie par chacun desquels passe l'une des électrodes, et dans lequel, dans chacune des électrodes, le tronçon intérieur s'étend entre la paroi et l'élément CPT et le tronçon extérieur s'étend sur l'autre côté de la paroi, éloigné de l'élément CPT.

9.  Dispositif de protection de circuit selon l'une quelconque des revendications précédentes, en combinaison, dans un circuit électrique, avec

(a) une source d'énergie ayant une tension V qui est d'au moins 20 volts en courant continu ; et

(b) une charge électrique ; dans lequel les deux électrodes du dispositif de protection de circuit sont connectées électriquement en série avec la charge et avec la source d'énergie pour faire passer ledit courant à travers la charge et l'élément CPT.

10. Circuit électrique selon la revendication 9, qui est sujet à des défaillances à des tensions supérieures à 200 volts en courant alternatif.

11. Procédé de réalisation d'un dispositif selon la revendication 8 par l'insertion d'un dispositif selon l'une quelconque des revendications 1 à 7 dans une paroi rigide, de préférence une plaquette à circuit.

**Patentansprüche**

1.  Schaltungsschutzeinrichtung, umfassend:

(1) ein PTC-Element, das aus einer leitfähigen Polymerzusammensetzung mit PTC-Verhalten besteht, die eine Polymerkomponente sowie in der Polymerkomponente dispergiert einen teilchenförmigen leitfähigen Füllstoff umfaßt; und

(2) zwei Elektroden, die mit dem PTC-Element elektrisch verbunden und an eine Stromquelle anschließbar sind, um zu bewirken, daß Strom durch das PTC-Element fließt, und um auf diese Weise zu bewirken, daß das PTC-Element sich selbst auf eine Schalttemperatur $T_s$ erwärmt und entlang einer Ausdehnungsachse ausdehnt unter Erzeugung von Ausdehnungskräften, die auf die Elektroden übertragen werden;

wobei wenigstens eine der Elektroden umfaßt

(a) einen ersten Teil, der mit dem PTC-Element entweder direkt oder indirekt über ein aus einem leitfähigen Polymer bestehendes Element in physischem Kontakt ist,

(b) einen zweiten inneren Teil, der mit dem PTC-Element nicht in Kontakt ist, und

(c) einen dritten äußeren Teil, der mit dem PTC-Element nicht in Kontakt ist;

wobei der innere Teil zwischen dem ersten Teil und dem äußeren Teil liegt und parallel zu der Ausdehnungsachse des PTC-Elements eine Biegesteifigkeit hat, die geringer als die Biegesteifigkeit des äußeren Teils parallel zu der Ausdehnungsachse des PTC-Elements ist, wobei die Einrichtung zum Einbau in eine starre Wand geeignet ist derart, daß der innere Teil der Elektrode zwischen der Wand und dem PTC-Element liegt und der äußere Teil der Elektrode auf der anderen, von dem PTC-Element fernen Seite der Wand liegt.

2. Einrichtung nach Anspruch 1, wobei der innere Teil eine Biegesteifigkeit von weniger als dem 0,75fachen der Biegesteifigkeit des äußeren Teils hat.

3. Einrichtung nach Anspruch 1 oder 2, wobei die ersten Teile der Elektroden parallel zueinander verlaufen, säulenförmig und von dem PTC-Element umgeben sind.

4. Einrichtung nach Anspruch 1, 2 oder 3, wobei die Elektroden im wesentlichen identisch sind.

5. Einrichtung nach einem der vorhergehenden Ansprüche, wobei jede Elektrode ein einziges massives Metallstück ist.

6. Einrichtung nach einem der vorhergehenden Ansprüche, wobei jede Elektrode eine Querschnittsfläche, die über ihre Gesamtlänge gleich ist, und einen inneren Teil aufweist, der wenigstens einen Abschnitt enthält, in dem die Querschnittsabmessung parallel zu der Ausdehnungsachse des PTC-Elements weniger als das 0.8fache der durchschnittlichen Querschnittsabmessung des inneren Teils parallel zu der Ausdehnungsachse des PTC-Elements ist.

7. Einrichtung nach einem der vorhergehenden Ansprüche, wobei jede Elektrode umfaßt: einen ersten Teil und einen inneren Teil, die als einziges Stück Metallitzendrahts ausgebildet sind, und einen äußeren Teil, der ein Volldraht ist.

8. Einrichtung nach einem der vorhergehenden Ansprüche, umfassend eine starre Wand, die von dem PTC-Element beabstandet ist und zwei Auslaßöffnungen enthält, durch die jeweils eine der Elektroden verläuft, und wobei bei jeder Elektrode der innere Teil zwischen der Wand und dem PTC-Element und der äußere Teil auf der anderen, von dem PTC-Element fernen Seite der Wand liegt.

9. Schaltungsschutzeinrichtung nach einem der vorhergehenden Ansprüche in Kombination mit einer Schaltung mit

(a) einer Stromquelle mit einer Spannung V, die eine Gleichspannung mit wenigstens 20 V ist; und

(b) einer elektrischen Last;

wobei die beiden Elektroden der Schaltungsschutzeinrichtung mit der Last und mit der Stromquelle elektrisch in Reihe geschaltet sind, um zu bewirken, daß Strom durch die Last und das PTC-Element fließt.

10. Elektrische Schaltung nach Anspruch 9, die bei Wechselspannungen mit mehr als 200 V störungsanfällig ist.

11. Verfahren zur Herstellung der Einrichtung nach Anspruch 8 durch Einbau einer Einrichtung nach einem der Ansprüche 1 bis 7 in eine starre Wand, bevorzugt eine Leiterplatte.

FIG_1

FIG_2

*FIG_3*

*FIG_4*

*FIG_5*

*FIG_6*

FIG_7

FIG_8

FIG_9